# EUROPÄISCHE PATENTANMELDUNG

(11) **EP 1 936 708 A2**
(43) Veröffentlichungstag der Anmeldung: **25.06.2008**
(21) Anmeldenummer: 07119451.8
(22) Anmeldetag: 29.10.2007
(51) Int. Cl.: H01L 41/053

(54) **Aktormodul mit einem umhüllten Piezoaktor und Verfahren zu dessen Herstellung**

(30) Priorität: 18.12.2006 DE 102006059694
(71) Anmelder: ROBERT BOSCH GMBH, 70442 Stuttgart (DE)
(72) Erfinder: Kuhlmann, Kai, 96050 Bamberg (DE); Dirscherl, Florian, 96052 Bamberg (DE); Bormann, Axel, 96049 Bamberg (DE)

(57) **Zusammenfassung**

Es wird ein Aktormodul (20) mit einem Piezoaktor (21), beispielsweise für einen Piezoinjektor zur Dosierung von Kraftstoff in einem Verbrennungsmotor, vorgeschlagen, wobei zwischen einem Aktorkopf (22) und einem Aktorfuß (23) angeordnete Piezoelemente (24) und eine mindestens die Piezoelemente (24) umschließende flüssigkeitsdichte Umhüllung des Piezoaktors (21) vorhanden sind. Die Umhüllung besteht aus einem Stützgerüst (25) und einem auf die Kontur des Stützgerüstes (25) mit entsprechenden vorteilhaften Herstellungsverfahren aufgebrachten Wellbalg (26;26',26").

## Beschreibung

### Stand der Technik

Die Erfindung betrifft ein Aktormodul mit einem eine Umhüllung aufweisenden Piezoaktor, gemäß der Gattung des Hauptanspruchs 1, der beispielsweise in einem Piezoinjektor zur zeitpunkt- und mengengenauen Dosierung von Kraftstoff in einem Verbrennungsmotor eingesetzt werden kann.

Ein solcher Piezoinjektor besteht im Wesentlichen aus einem Haltekörper und dem im Haltekörper angeordneten Piezoaktor, der zwischen einem Aktorkopf und einem Aktorfuß angeordnete, übereinandergestapelte Piezoelemente aufweist, die jeweils aus mit Innenelektroden eingefassten Piezolagen bestehen. Die Piezoelemente sind unter Verwendung eines Materials mit einer geeigneten Kristallstruktur (Piezokeramik) für die Piezolagen so aufgebaut, dass bei Anlage einer äußeren Spannung an die Innenelektroden eine mechanische Reaktion der Piezoelemente erfolgt, die in Abhängigkeit von der Kristallstruktur und der Anlagebereiche der elektrischen Spannung einen Druck oder Zug in eine vorgebbare Richtung darstellt. Der Piezoaktor ist beispielsweise im direkten Betrieb bei einem Piezoinjektor mit einer Düsennadel verbunden, sodass durch Anlegen einer Spannung an die Piezoelemente eine Düsenöffnung wie bei einem Ventil freigegeben wird. Es ist jedoch auch ein indirekter oder inverser Betrieb mit dem Piezoaktor möglich.

In Diesel-Piezoinjektoren werden bei der so genannten direkten Düsennadelsteuerung die Piezoaktoren direkt im Dieselkraftstoff unter Hochdruck betrieben. Zum Schutz der Piezoelemente, beispielsweise im Hinblick auf deren elektrische Isolation, ist es bekannt, den Piezoaktor mit einem Elastomer zu umhüllen. Da die Anwesenheit von Kraftstoff, insbesondere hinsichtlich seiner leitfähigen Bestandteile, auf der Oberfläche des Piezoaktors zu einem elektrischen Überschlag zwischen den Elektroden und somit dem Versagen des Piezoaktors führen würde, muss der Piezoaktor vor dem direkten Kontakt mit dem Kraftstoff geschützt werden. Nachteilig bei der Verwendung der zuvor erwähnten Materialien ist dabei, dass die hierfür verwendeten Elastomere nicht dauerhaft diffusionsfest gegenüber Dieselkraftstoff, Wasser sowie sonstigen Medien im Kraftstoff sind.

Aus der DE 101 39 871 A1 ist ein Piezoinjektor mit einem über einen hydraulischen Druckübersetzer auf ein Ventilglied einwirkenden Aktormodul bekannt, bei dem die Piezoelemente des Piezoaktors in einer mit einem metallischen Wellbalg versehenen Umhüllung angeordnet sind. Weiterhin ist bisher ist auch die Ummantelung des Aktormoduls mit einem geschweißten Metallgehäuse mit Membran und Silikonfüllung bekannt.

### Offenbarung der Erfindung

Die Erfindung geht von einem eingangs beschriebenen Aktormodul mit einem Piezoaktor aus, der zwischen einem Aktorkopf und einem Aktorfuß angeordnete Piezoelemente und eine mindestens die Piezoelemente umgebende flüssigkeitsdichte Umhüllung aufweist. Erfindungsgemäß besteht die Umhüllung in vorteilhafter Weise aus einem Stützgerüst und einem auf die Kontur des Stützgerüstes aufgebrachten Wellbalg. Das Stützgerüst kann dabei aus Kunststoff, vorzugsweise ein Thermoplast, ein Duroplast oder eine Elastomer und der Wellbalg aus einem unter Druck verformbaren Stahl, z. B. 1.4301, gebildet sein. Der Wellbalg ist in vorteilhafter Weise am Aktorkopf und/oder am Aktorfuß verschweißt, zum Beispiel durch Laser- oder Elektronenstrahlschweißen.

Das Stützgerüst und der Wellbalg des erfindungsgemäßen Aktormoduls können dabei zumindest im Bereich der Piezoelemente eine dem vorzugsweise quadratischen Querschnitt der Piezoelemente bzw. des Piezoaktors entsprechende Kontur aufweisen. Dies ist insbesondere bei einer Verwendung des Aktormoduls als Bestandteil eines Piezoinjektors für ein Einspritzsystem für Kraftstoff bei einem Verbrennungsmotor vorteilhaft, bei der der Kraftstoff die Umhüllung umströmt.

Bei einem erfindungsgemäßen Verfahren zur Herstellung eines Aktormoduls wird in einem ersten Verfahrensschritt das Stützgerüst auf den Piezoaktor aufgebracht, in einem zweiten Verfahrensschritt wird eine Hülse auf den Piezoaktor aufgezogen, in einem dritten Verfahrensschritt wird die Hülse am Aktorkopf und/oder am Aktorfuß verschweißt und in einem vierten Verfahrensschritt wird durch Aufbringen eines äußeren Drucks die Hülse auf die Kontur des Stützgerüstes aufgeformt, sodass sich aus der Hülse ein Wellbalg entsprechend der Kontur des Stützgerüstes formt, der die Bewegungen des Piezoaktors aufnehmen kann.

Das Stützgerüst kann dabei auf einfache Weise durch Umspritzen oder Umgießen des Piezoaktors bzw. durch Aufziehen eines bereits vorgefertigten, vorzugsweise mit einem Übermaß versehenen Stützgerüstes aufgebracht werden. Beim Umspritzen des Piezoaktors, zum Beispiel mit einem Thermoplast, ist es vorteilhaft, dass hier die Prozesszeiten kurz sind. Der Kunststoffkern als Stützgerüst würde dabei beispielsweise bei einer Maximalauslenkung ca. 30N Gegenkraft entwickeln. Das Umgießen des Piezoaktors wäre ebenfalls einfach zu bewerkstelligen, es würde jedoch länger dauern als ein Umspritzen, wobei hier als Werkstoffe Duroplaste, Thermoplaste oder PUR in Betracht kämen. Beim Aufziehen eines bereits vorgefertigten Stützgerüstes auf den Piezoaktor, wobei man dieses Stützgerüst anschließend im Kraftstoffdruck anformen kann, wäre durch das Übermaß die Beschädigungsgefahr sehr klein und diese Ausführung des Stützgerüstes könnte auch kostengünstig vorgefertigt oder zugekauft werden.

Der den Piezoaktor schützende Wellbalg bzw. die Hülse als Rohzustand kann dabei in vorteilhafter Weise durch den Betriebsdruck des Kraftstoffs oder durch einen vorher aufgebrachten Druck aufgeformt werden und das Stützgerüst bleibt als Kern des Wellbalgs im Aktormodul erhalten. Um ein Aufbiegen des Wellbalges bei einem Stillstand, d. h. es ist kein Druck mehr im Piezoinjektor, zu vermindern, könnte eine Evakuierung der Hülse vor dem Verschweißen notwendig sein. Als Schweißverfahren bieten sich dabei, wie erwähnt, das Laserschweißen oder das Elektronenstrahlschweißen an, das ohnehin im Vakuum ausgeführt wird.

Die Wellen des Wellbalges bzw. sein Querschnitt können dabei von der vorherrschenden runden Form abweichen und eventuell, wie zuvor erwähnt, der quadratischen Form des Piezoaktors entsprechen. Dadurch wird Bauraum frei und es kann der Kraftstoff seitlich am Piezoaktor vorbeifließen, sodass der Betrieb des Aktormoduls mit dem Wellbalg auch unter hohem Druck, z. B. ca. 2000 bar, möglich ist.

Gemäß eines weiteren vorteilhaften Verfahrens zur Herstellung des erfindungsgemäßen Aktormoduls wird in einem ersten Verfahrensschritt das Stützgerüst zusammen mit dem Wellbalg, der auf die Kontur des Stützgerüstes bereits aufgeformt ist, auf den Piezoaktor aufgezogen und in einem zweiten Verfahrensschritt wird der Wellbalg am Aktorkopf und/oder am Aktorfuß verschweißt.

Weiterhin könnte auch in einen konventionell hergestellten Wellbalg ein Kern oder Stützkörper aus Kunststoff eingespritzt und anschließend aufgezogen werden.

### Kurze Beschreibung der Zeichnungen

Die Erfindung wird nachfolgend anhand der in den Zeichnungen gezeigten Ausführungsbeispiele erläutert. Dabei zeigen:
Figur 1 eine schematische Darstellung eines Piezoinjektors mit einem Aktormodul nach dem Stand der Technik im Längsschnitt,
Figur 2 eine Darstellung von Teilen eines erfindungsgemäßen Aktormoduls mit einer Umhüllung eines Piezoaktors im Aktormodul, bestehend aus einem Wellbalg auf einem Stützgerüst und
Figur 3 einen Schnitt durch das Aktormodul nach der Figur 2 mit einem an den quadratischen Querschnitt des Piezoaktors im Bereich der Piezoelemente angepassten Wellbalg.

### Ausführungsformen der Erfindung

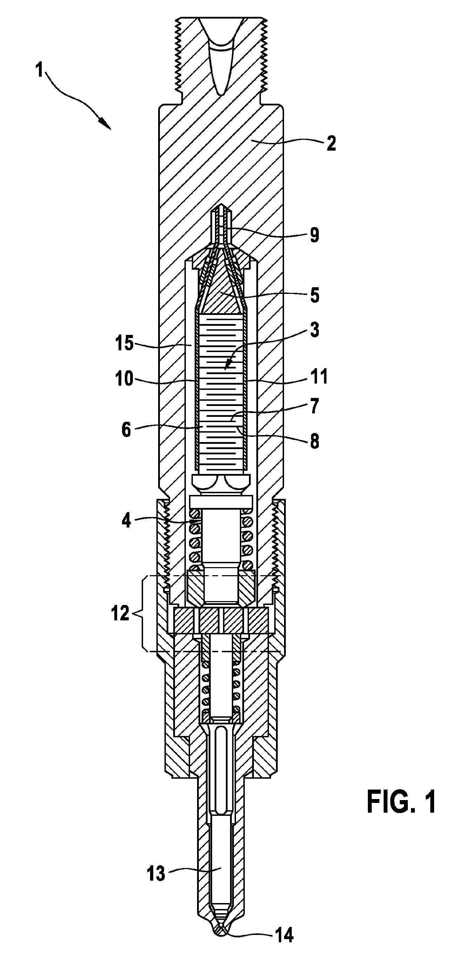

Ein in Figur 1 zur Erläuterung des erfindungemäßen Aktormoduls dargestellter Piezoinjektor 1 nach dem Stand der Technik umfasst im Wesentlichen einen Haltekörper 2 und einen in dem Haltekörper 2 angeordneten Piezoaktor 3, der ein Aktorkopf 4 und einen Aktorfuß 5 aufweist. Es sind dabei zwischen dem Aktorkopf 4 und dem Aktorfuß 5 mehrere übereinandergestapelte Piezoelemente 6 vorhanden, die jeweils aus Piezolagen aus Piezokeramik und diese einschließende Innenelektroden 7 und 8 bestehen.

Die Innenelektroden 7 und 8 der Piezoelemente 6 sind über ein Steckerteil 9 mit Zuleitungen zu Außenelektroden 10 und 11 elektrisch kontaktiert. Der Piezoaktor 3, der mit weiteren, hier nicht näher gezeigten Bauteilen ein sogenanntes Aktormodul darstellt, ist über einen Koppler 12 mit einer Düsennadel 13 verbunden. Durch Anlegen einer Spannung an die Piezoelemente 6 über die Innenelektroden 7 und 8 und die daraus folgende mechanische Reaktion wird, wie in der Beschreibungseinleitung erläutert, eine Düsenöffnung 14 freigegeben. Das Aktormodul mit dem Piezoaktor 3 wird bei der dargestellten Anwendung nach der Figur 1 als Piezoinjektor in einem Raum 15 von dem zu dosierenden Kraftstoff, zum Beispiel Dieselkraftstoff, umströmt.

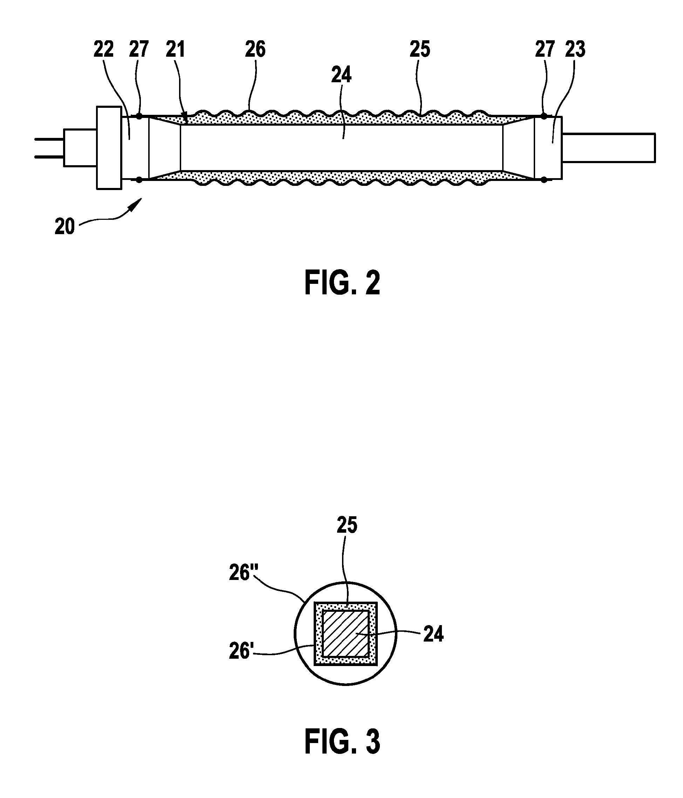

In Figur 2 ist ein erfindungsgemäßes Aktormodul 20 mit einem Piezoaktor 21 dargestellt, der hier vom Aktorkopf 22 zum Aktorfuß 23 einschließlich der Piezoelemente 24 des Piezoaktors 21 mit einem elektrisch isolierenden Stützgerüst 25 umgeben ist. Um das Stützgerüst 25 herum befindet sich ein metallischer Wellbalg 26 als flüssigkeitsdichte Umhüllung, der auf die Kontur des Stützgerüstes 25 aufgeformt ist. Der Wellbalg 26 ist an seinen beiden Enden mit jeweils einer Schweißverbindung 27 mit dem Aktorkopf 22 und dem Aktorfuß 23 verbunden. Der Wellbalg 26 dient dabei sowohl einer diffusionsdichten Abdichtung der Piezoelemente 24 gegenüber einem umgebenden Kraftstoff eines Piezoinjektors, als auch einem elastischen Auffangen von thermischen und mechanischen Längsdehnungen des Piezoaktors 21.

Der Wellbalg 26 wird auf dem Piezoaktor 21 derart angeordnet, dass zunächst das Stützgerüst 25 als ein Thermoplast (PA6 oder vergleichbares), ein Duroplast oder ein Elastomer durch Umspritzen oder Umgießen des Piezoaktors 21 bzw. durch Aufziehen eines bereits vorgefertigten, vorzugsweise mit einem Übermaß versehenen Stützgerüstes 25 aufgebracht wird. In einem zweiten Herstellungsschritt wird der Wellbalg 26 zunächst als Hülse auf den Piezoaktor 21 aufgezogen, in einem dritten Schritt wird die Hülse am Aktorkopf 22 und/oder am Aktorfuß 23 verschweißt, und dann wird durch Aufbringen eines äußeren Drucks der Wellbalg 26 aus der Hülse auf die Kontur des Stützgerüstes 25 aufgeformt, damit die aus der Figur 2 zu entnehmende Kontur des Wellbalges 26 entsteht.

Aus Figur 3 ist eine Ansicht auf einen Schnitt zu entnehmen, bei dem das Stützgerüst 25 und der Wellbalg 26' zumindest im Bereich der Piezoelemente 24 eine dem vorzugsweise quadratischen Querschnitt der Piezoelemente 24 entsprechende Kontur aufweisen. Im Bereich des Aktorkopfes 22 und/oder des Aktorfußes 23 weist der Wellbalg 26" jedoch einen runden Querschnitt auf, um einen formschlüssigen Anschluss zu gewährleisten.

Alternativ zu den zuvor beschriebenen Anordnungen kann das Stützgerüst 25 jedoch auch auf den Piezoaktor 21 durch Aufziehen eines bereits vorgefertigten, vorzugsweise mit einem Übermaß versehenen Stützgerüstes 25 aufgebracht werden, wobei man dieses Stützgerüst 25 anschließend im Kraftstoffdruck anformen kann. Andererseits kann aber auch das Stützgerüst 25 zusammen mit einem bereits aufgeformten Wellbalg 26 auf den Piezoaktor 21 aufgezogen werden und dann am Aktorkopf 22 und/oder am Aktorfuß 23 verschweißt werden.

## Patentansprüche

1. Aktormodul mit einem Piezoaktor (3), der zwischen einem Aktorkopf (4) und einem Aktorfuß (5) angeordnete Piezoelemente (6) aufweist, mit einer mindestens die Piezoelemente (6) umschließenden flüssigkeitsdichten Umhüllung des Piezoaktors (3), **dadurch gekennzeichnet, dass** die Umhüllung aus einem Stützgerüst (25) und einem auf die Kontur des Stützgerüstes (25) aufgebrachten Wellbalg (26;26',26") besteht.

2. Aktormodul nach Anspruch 1, **dadurch gekennzeichnet, dass** das Stützgerüst (25) aus Kunststoff und der Wellbalg (26;26',26") aus einem unter Druck verformbaren Metall gebildet ist.

3. Aktormodul nach Anspruch 2, **dadurch gekennzeichnet, dass** der Kunststoff des Stützgerüstes (25) ein Thermoplast, ein Duroplast oder ein Elastomer ist.

4. Aktormodul nach einem der vorhergehenden Ansprüche, **dadurch gekennzeichnet, dass** der Wellbalg (26;26',26") am Aktorkopf (22) und/oder am Aktorfuß (23) angebunden ist.

5. Aktormodul nach Anspruch 4, **dadurch gekennzeichnet, dass** der Wellbalg (26;26',26") am Aktorkopf (22) und/oder am Aktorfuß (23) durch Schweißen oder vergeleichbare Fügeverfahren angebunden ist.

6. Aktormodul nach einem der vorhergehenden Ansprüche, **dadurch gekennzeichnet, dass** das Stützgerüst (25) und der Wellbalg (26;26',26") zumindest im Bereich der Piezoelemente (24) eine dem vorzugsweise quadratischen Querschnitt der Piezoelemente (24) entsprechende Kontur aufweisen.

7. Verfahren zur Herstellung eines Aktormoduls nach einem der vorhergehenden Ansprüche, **dadurch gekennzeichnet, dass** in einem ersten Verfahrensschritt das Stützgerüst (25) auf den Piezoaktor (21) aufgebracht wird, in einem zweiten Verfahrensschritt eine Hülse als Vorform des Wellbalges (26;26',26") auf den Piezoaktor (21) aufgezogen wird, in einem dritten Verfahrensschritt die Hülse am Aktorkopf (22) und/oder am Aktorfuß (23) verschweißt wird und in einem vierten Verfahrensschritt durch Aufbringen eines äußeren Drucks der Wellbalg (26;26',26") aus der Hülse auf die Kontur des Stützgerüstes (25) aufgeformt wird.

8. Verfahren nach Anspruch 7, **dadurch gekennzeichnet, dass** das Stützgerüst (25) auf den Piezoaktor (21) durch Umspritzen oder Umgießen des Piezoaktors (21) aufgebracht wird.

9. Verfahren nach Anspruch 7, **dadurch gekennzeichnet, dass** das Stützgerüst (25) auf den Piezoaktor (21) durch Aufziehen eines bereits vorgefertigten, vorzugsweise mit einem Übermaß versehenen Stützgerüstes (25) aufgebracht wird.

10. Verfahren zur Herstellung eines Aktormoduls nach einem der Ansprüche 1 bis 6, **dadurch gekennzeichnet, dass** in einem ersten Verfahrensschritt das Stützgerüst (25) zusammen mit einem Wellbalg (26;26',26"), der auf die Kontur des Stützgerüstes (25) aufgeformt ist, auf den Piezoaktor (21) aufgezogen wird und in einem zweiten Verfahrensschritt der Wellbalg (26;26',26") am Aktorkopf (22) und/oder am Aktorfuß (23) verschweißt wird.

11. Verwendung eines Aktormoduls nach einem der vorhergehenden Ansprüche, **dadurch gekennzeichnet, dass** der Piezoaktor (21) Bestandteil eines Piezoinjektors für ein Einspritzsystem für Kraftstoff bei einem Verbrennungsmotor ist, wobei der Kraftstoff die Umhüllung mit dem Wellbalg (26;26',26") umströmt.
